# EUROPÄISCHE PATENTSCHRIFT

(11) **EP 1 085 398 B1**
(45) Veröffentlichungstag und Bekanntmachung des Hinweises auf die Patenterteilung: **04.02.2004**
(21) Anmeldenummer: 00120076.5
(22) Anmeldetag: 15.09.2000
(51) Int. Cl.: G06F 1/18, H05K 7/14, G11B 33/12

(54) **Befestigung für Laufwerk eines Computers**
Fastening device for computer drive
Fixation pour un lecteur d' ordinateur

(30) Priorität: 17.09.1999 DE 19944553
(43) Veröffentlichungstag der Anmeldung: 21.03.2001
(73) Patentinhaber: IN Blechverarbeitungszentrum Sömmerda GmbH, 99610 Sömmerda (DE)
(72) Erfinder: Sternberg, Randolph, 55239 Gau Odernheim (DE); Welker, Klaus, 60437 Frankfurt (DE); Kohlmann, Kai, 99099 Erfurt (DE); Hergt, Susen, 99631 Weissensee (DE); Wellhöfer, Stefan, 99195 Schlossvippach (DE)
(74) Vertreter: Strobel, Wolfgang, Dipl.-Ing.

(56) Entgegenhaltungen:
- DE-U- 29 607 138
- US-A- 4 766 652
- US-A- 5 137 248
- US-A- 5 398 156
- US-A- 5 691 879

## Beschreibung

Die Erfindung bezieht sich auf eine Befestigung für ein Laufwerk eines Computers mit Computergehäuse, in das das Laufwerk einschiebbar ist, das seinerseits bodenseitig Befestigungsaufnahmen aufweist.

Das Konfektionieren von Computern erfolgt heutzutage am Fließband, wobei jedoch die einzusetzenden Bauteile von Hand befestigt werden. Dabei werden Laufwerke üblicherweise auf von den Computergehäusen ausgehenden Schienen aufgebracht und sodann bodenseitig mittels Schrauben befestigt, die Löcher in den Schienen sowie im Boden des Laufwerkes durchdringen. Die entsprechenden Arbeiten bedürfen einer genauen Ausrichtung von Laufwerk und Schiene sowie das anschließende Anziehen der Schrauben. Dies ist zeitaufwendig und somit ein nicht zu vernachlässigender Kostenfaktor bei der Herstellung von Computern.

Aber nicht nur bei der Montage eines herzustellenden Computers, sondern auch bei der Wartung und gegebenenfalls Austausch von beschädigten Bauelementen sind durch entsprechende Befestigungen Nachteile gegeben, zumal in dem Computergehäuse selbst nur wenig Raum zur Verfügung steht, um die entsprechenden Befestigungselemente richtig zu positionieren und zu erfassen.

Der vorliegenden Erfindung liegt das Problem zu Grunde, eine Befestigung der eingangs genannten Art so weiterzubilden, dass ein sicherer, montagefreundlicher und zeitsparender Ein- und Ausbau sowie Fixierung des Laufwerks möglich ist.

Erfindungsgemäß wird das Problem durch die Merkmale in kennzeichnenden Teil des Anspruchs 1 gelöst.

Abweichend vom vorbekannten Stand der Technik werden Laufwerke nicht mehr über Schrauben in dem Computergehäuse befestigt und somit fixiert. Vielmehr werden allein Klemm- bzw. Federelemente verwendet, um auf das Laufwerk Kräfte in Richtung von Fixierelementen wie Stiften oder Abstandshaltern einwirken zu lassen, die ein sicheres Festlegen des Laufwerks sicherstellen. Dabei ist in Bezug auf das Laufwerk eine Umkonstruktion nicht erforderlich, da die bereits bodenseitig vorhandenen Befestigungsaufnahmen wie Löcher weiterhin zum Fixieren des Laufwerks benutzt werden, ohne dass es Schrauben bedarf.

So ist das Laufwerk zwischen bodenseitig in die Befestigungsaufnahmen wie Bohrungen eingreifenden Stiften und auf gegenüberliegender Seite sich abstütztendem Federelement fixiert. Dabei ist das Federelement insbesondere ein schwenkbar gelagertes Bügelelement, das in Abhängigkeit seiner Stellung auf das Laufwerk eine in Richtung der Stifte gerichtete Kraft einleitet oder beabstandet zu diesem verläuft. Letzteres eröffnet die Möglichkeit, durch Anheben des Laufwerkes, damit die Stifte in Ausgriff mit den bodenseitigen Befestigungsaufnahmen gelangen, und anschließendes Herausziehen das Laufwerk zu entfernen bzw. in umgekehrter Reihenfolge ein Laufwerk einzusetzen und zu fixieren.

Das Bügelelement selbst ist zwischen parallel zueinander verlaufenden z. B. durch Platten gebildeten Wandungen gelagert, von denen die in die Befestigungsaufnahmen eingreifenden Stifte ausgehen. Außenseitig entlang einer der Wandungen verläuft eine Handhabe des Bügelelementes, die integral mit diesem ausgebildet ist.

Dabei ist bei festgelegter wie verrasteter Handhabe des Bügelelementes das Laufwerk in Richtung der Stifte kraftbeaufschlagt.

Das Bügelelement wie Federelement weist insbesondere zwei mit dem Laufwerk wechselwirkende Abschnitte auf, wobei im Bereich zur von dem Laufwerk aufgespannter Ebene senkrecht verlaufender Projektion der bogenförmigen Abschnitte Stifte oder eine Gerade verlaufen. auf der zwei vorzugsweise von einer gemeinsamen Wandung ausgehende Stifte liegen. Hierdurch wird eine gezielte Krafteinwirkung über den Federbügel auf das Laufwerk in Richtung der Stifte hervorgerufen, wodurch eine sichere Fixierung möglich ist. Durch das Federelement ist jedoch gleichzeitig sichergestellt, dass das Laufwerk in hinreichendem Umfang elastisch gelagert ist, um gegebenenfalls Stöße abzufedern.

Das Bügel- bzw. Federelement weist insbesondere eine L-förmige Geometrie auf und besteht aus Federdraht. Dabei gehen vom langen Schenkel auf das Laufwerk einwirkende Vorsprünge aus, die zu den Stiften bzw. Vorsprüngen dann parallel verlaufen, wenn das Laufwerk fixiert ist. Dabei können die verschwenkbaren Abschnitte auf die Stifte ausgerichtet sein oder zwischen den von einer Wandung ausgehenden verlaufen. Der kurze Schenkel des Bügel- bzw. Federelements bildet die Handhabe.

Es zeigen:
- Fig. 1: eine Vorderansicht eines in einem Computergehäuse fixierten Laufwerkes, und
- Fig. 2: die Unterseite des Laufwerkes gemäß Fig. 1.

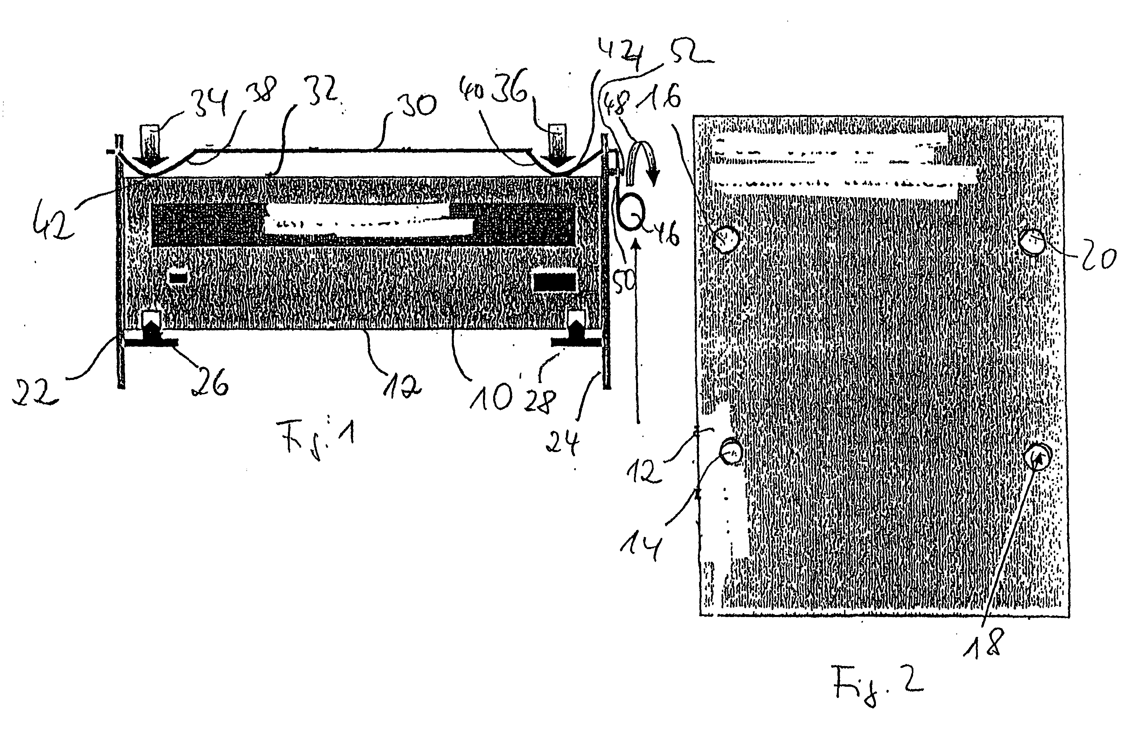

Um ein Laufwerk 10 schraublos in einem Computergehäuse zu fixieren, ohne dass es einer Änderung der bisher zum Einsatz gelangenden Laufwerke in Bezug auf Abmessung bzw. Ausbildung der Bodenwandung 12 des Laufwerks 10 bedarf, werden die in dieser vorhandenen Befestigungslöcher 14, 16, 18 und 20 benutzt, in die von parallel zueinander vedaufenden plattenförmigen Wandungen 22, 24 ausgehende Stifte 26, 28 eingreifen. Die Stifte 26, 28 sind konisch zur Spitze hin verjüngt, um eine Zentrierhilfe und ein sicheres Eingreifen in die Löcher 14, 16, 18, 20 zu gewährleisten.

Von den Plattenelementen bzw. Wandungen 22, 24 geht des Weiteren zumindest ein in diesen schwenkbar gelagertes Bügelelement 30 aus, das dann, wenn die Stifte 26, 28 in die Befestigungslöcher 14, 16, 18, 20 eingreifen, an oberer Wandung 32 des Laufwerks 10 abstützbar ist, um auf diese Weise eine Kraft in Richtung der Stifte 26, 28 hervorzurufen. Dies wird durch die Pfeile 34, 36 prinzipiell angedeutet.

Hierzu weist der Federbügel 30 zwei U- oder V-förmig ausgebildete Bogenabschnitte 38, 40 auf, deren Spitzen 42, 44 mit der oberen Wandung 32 des Laufwerkes 10 in einem Bereich wechselwirken. der unmittelbar oberhalb der Stifte 26, 28 bzw. einer Geraden verläuft, auf der die von der jeweiligen gemeinsamen Wandung 22, 24 ausgehenden Stifte 26, 28, die in die Befestigungslöcher 14, 16 bis 18, 20 eingreifen, liegen.

Mit anderen Worten verlaufen parallel zu den Wandungen 22, 24 sich erstreckende Projektionen der bogenförmigen Abschnitte 38, 40 des Bügelelementes 30 im Bereich der Stifte 26, 28.

Um das Bügelelement 30 verschwenken zu können, um also entweder das Bügelelement 30 über dessen bogenförmige Abschnitte 38, 40 auf dem Laufwerk 10 abzustützen oder beabstandet zu diesem verlaufen zu lassen, ist eine Handhabe 46 vorgesehen, die als äußerer Abschnitt des Bügelelementes 30 ausgebildet ist und sich entlang einer Außenseite eines der Plattenelemente, im Ausführungsbeispiel entlang der Außenseite des Plattenelementes 24 erstreckt. Durch diesen abgewinkelten Abschnitt des Bügelelementes 30 ist dieses im erforderlichen Umfang verschwenkbar, wie durch den Pfeil 48 verdeutlicht wird. Dabei ist die Handhabe 46 dann, wenn die bogenförmigen Abschnitte 38, 40 die erforderliche Kraftbeaufschlagung auf das Laufwerk 10 in Richtung der Stifte 26, 28 hervorrufen, festlegbar wie verrastbar. Die Handhabe 46 ist dabei mit einem parallel zu der Wandung 24 verlaufenden Abschnitt 50 in einer entsprechenden Aufnahme 52 festlegbar, die von der Wandung 24 ausgeht.

Das Bügelelement 30 weist hierzu insbesondere eine L-förmige Geometrie auf, dessen langer Schenkel die bogenförmigen Abschnitte 38, 40 aufweist und dessen kurzer Schenke die Funktion der Handhabe 46 ausübt. Das Fixieren des Laufwerks 10 ist mit einem einzigen Federbügelement 30 möglich. Selbstverständlich können auch mehrere entsprechende Federbügel entlang der Oberseite eines Laufwerkes 10 verlaufen.

Ist in dem Ausführungsbeispiel prinzipiell das Laufwerk 10 als CD bzw. DVD-Laufwerk dargestellt, so ist die erfindungsgemäße Lehre selbstverständlich für sonstige in einem Computer vorhandene Laufwerke wie Diskettenlaufwerke nutzbar.

## Patentansprüche

1. Befestigung für ein Laufwerk (10) eines Computers mit Computergehäuse, in das das Laufwerk einschiebbar ist, das seinerseits bodenseitig Befestigungsaufnahmen (14, 16, 18, 20) aufweist, wobei das Laufwerk (10) schraublos in dem Computergehäuse durch Klemmung fixiert ist,
**dadurch gekennzeichnet, daß**
das Laufwerk zwischen bodenseitig in die Befestigungsaufnahmen (14, 16, 18, 20) eingreifenden Stiften (26, 28) und auf gegenüberliegender Seite (32) des Laufwerks sich abstützendem, schwenkbar gelagertem Bügelelement (30) fixiert ist.

2. Befestigung nach Anspruch 1, **dadurch gekennzeichnet, daß** das Bügelelement (30) eine außenseitig entlang einer der Wandungen (24), zwischen denen das Laufwerk (10) anordbar ist, verlaufende festlegbare Handhabe (46) aufweist, und daß bei festgelegtem wie verrastetem Bügelelement dieses das Laufwerk (10) in Richtung der Stifte (26, 28) beaufschlagt.

3. Befestigung nach Anspruch 1 oder 2, **dadurch gekennzeichnet, daß** das Bügelelement (30) in Abhängigkeit von seiner Stellung auf das Laufwerk (10) eine in Richtung der Stifte (26, 28) gerichtete Kraft einleitet oder beabstandet zu diesem verläuft.

4. Befestigung nach einem der vorangehenden Ansprüche, **dadurch gekennzeichnet, daß** das Bügelelement (30) schwenkbar in den Wandungen (22, 24) gelagert ist, wobei das Bügelelement (30) mit dem Laufwerk wechselwirkende, vorzugsweise bogenförmige Vorsprünge bzw. Abschnitte (38, 40) aufweist.

5. Befestigung nach einem der vorangehenden Ansprüche, **dadurch gekennzeichnet, daß** parallel zu den Wandungen (22, 24) verlaufende Projektionen der bogenförmigen Abschnitte (38, 40) des Bügelelements (30) im Bereich der insbesondere innenseitig von den Wandungen ausgehenden Stifte (26, 28) oder im Bereich einer Geraden verlaufen, auf der zumindest zwei entlang einer gemeinsamen Wandung verlaufende Stifte liegen.

## Claims

1. Fastening for a drive (10) of a computer with a computer housing into which the drive can be inserted, which comprises fastening openings (14, 16, 18, 20) at its base, whereby the drive (10) is fixed in the computer housing by clamping without screws,
**characterised in that**
the drive is fixed between pins (26, 28) engaging the fastening openings (14, 16, 18, 20) at the base and a bracket element (30), which is supported on the opposite side (32) of the drive in a pivotal manner.

2. Fastening according to claim 1, **characterised in that** the bracket element (30) comprises a handle (46) which runs outside along one of the walls (24), between which the drive (10) can be arranged, and that the bracket, when fixed and locked in place, loads the drive (10) in the direction of the pins (26, 28).

3. Fastening according to claim 1 or 2, **characterised in that** the bracket element (30) introduces a force in the direction of the pins (26, 28) in dependence on its position to the drive (10) or runs with a distance thereto.

4. Fastening according to one of the preceding claims, **characterised in that** the bracket element (30) is mounted pivotally in the walls (22, 24), whereby the bracket element (30) comprises preferably arcuate projections or sections (38, 40) which are interacting with the drive.

5. Fastening according to one of the preceding claims, **characterised in that** the projections of the arcuate sections (38, 40) of the bracket element (30) running parallel to the walls (22, 24) run in the region of the pins (26, 28), which start off particularly from the walls, or run in the region of a straight line, on which are at least two pins which run along a common wall.

## Revendications

1. Fixation pour un lecteur d'un ordinateur présentant un coffret d'ordinateur dans lequel peut être inséré le lecteur, qui présente pour sa part des logements de fixation (14, 16, 18, 20) du côté inférieur, le lecteur (10) étant fixé sans vis, dans le coffret d'ordinateur,
**caractérisé en ce que**
le lecteur est fixé entre des goupilles (26, 28) pénétrant du côté inférieur dans les logements de fixation (14, 16, 18, 20) et un élément formant étrier (30) supporté pivotant, s'appuyant sur le côté opposé (32) du lecteur.

2. Fixation selon la revendication 1, **caractérisée en ce que** l'élément formant étrier (30) présente une poignée (46) pouvant être immobilisée qui s'étend extérieurement le long de l'une des parois (24) entre lesquelles le lecteur (10) peut être disposé, et **en ce que** lorsque l'élément formant étrier est immobilisé comme encliqueté, celui-ci presse le lecteur (10) dans la direction des goupilles (26, 28).

3. Fixation selon la revendication 1 ou 2, **caractérisée en ce qu'**en fonction de sa position sur le lecteur (10), l'élément formant étrier (30) induit une force orientée dans la direction des goupilles (26, 28) ou s'étend à distance de celui-ci.

4. Fixation selon l'une des revendications précédentes, **caractérisée en ce que** l'élément formant étrier (30) est supporté pivotant dans les parois (22, 24), l'élément formant étrier (30) présentant des saillies ou sections (38, 40) de préférence en forme d'arc, interagissant avec le lecteur.

5. Fixation selon l'une des revendications précédentes, **caractérisée en ce que**, s'étendant parallèlement aux parois (22, 24), des projections des sections en forme d'arc (38, 40) de l'élément formant étrier (30) s'étendent dans la zone des goupilles (26, 28), en partant en particulier intérieurement des parois ou dans la zone d'une droite, sur laquelle reposent au moins deux goupilles s'étendant le long d'une paroi commune.
